Europäisches Patentamt

European Patent Office

Office européen des brevets

(11) Publication number: **0 376 125**
**A2**

## (12) EUROPEAN PATENT APPLICATION

(21) Application number: **89123443.7**

(22) Date of filing: **19.12.89**

(51) Int. Cl.5: **H01L 31/108, H01L 31/18**

(30) Priority: **27.12.88 US 290071**

(43) Date of publication of application:
**04.07.90 Bulletin 90/27**

(84) Designated Contracting States:
**DE FR GB NL**

(71) Applicant: **HONEYWELL INC.**
**Honeywell Plaza**
**Minneapolis MN 55408(US)**

(72) Inventor: **Peczalski, Andrzej**
**9873 Balmoral Lane**
**Eden Prairie, MN 55344(US)**
Inventor: **Schwanebeck, James C.**
**9400 230th Street**
**Lakeville, MN 55044(US)**

(74) Representative: **Herzbach, Dieter et al**
**Honeywell Europe S.A. Holding KG Patent-**
**und Lizenzabteilung Kaiserleistrasse 39**
**Postfach 10 08 65**
**D-6050 Offenbach am Main(DE)**

(54) Infrared detector.

(57) A monolithic IR detector (10) having a Schottky barrier. The detector (10) is constructed with epitaxial engineering technology. The detector (10) is a moderately low-temperature and tuneable detector exhibiting respectable radiation hardness.

FIG. 1

## INFRARED DETECTOR

### Background of the Invention

The present invention pertains to a detector according to the preamble of the independent claims. In particular, the invention pertains to infrared (IR) sensitive Schottky barrier detectors. More particularly, the invention is a thin-layered semiconductor device that functions at low temperatures. Related art includes IR detectors having Schottky barriers and a superlattice structure.

Specifically in the related art are IR detectors that have fabricated Schottky diodes on GaAs with reduced barrier height (i.e., about or less than 0.2 electron volt) to provide IR with high quantum efficiency and low dark current. One particular fabrication has included the "PtSi" approach which involves depositing Pt on GaAs having $p^+$ of a concentration of $2 \times 10^{18}$ per cubic centimeter (cm3), and annealing at 350 degrees centigrade ($^\circ$C). This approach results in a 0.3 electron volt (eV) for good sensitivity. However, the problems with this related art IR detector include the separation of the Ga and As during annealing and an often contaminated Schottky interface which pins the Fermi energy level around the midgap thereby resulting in a reduced or no sensitivity by the detector.

It is therefore the object of the present invention to devise such a detector having improved sensitivity.

This object is achieved according to the characterizing features of the independent claims. Further advantageous embodiments of the inventive detector may be taken from the dependent claims.

### Summary of the Invention

The present invention is fabricated using a molecular epitaxy approach that incorporates in situ the growing of Al metal deposited on an epitaxial GaAs layer of 200 angstroms GaAs having $n^-$ in a concentration of $5 \times 10^{18}$ per cm3, which yields an approximate 0.1 eV Schottky barrier. Other substances such as WSi may used as metal for the Schottky barrier. The fabrication requires no annealing and is well-controlled and uniform.

The Schottky interfaces are processed in situ (without the breaking of high vacuum in the processing chamber) which results in clean interfaces. Such process is known in the art. The clean interface provides for an energy states free barrier in that the barrier stays in the middle of the energy band. Epitaxial technology makes the detector compatible with GaAs heterojunction integrated circuitry. The GaAs IR detector can be fabricated on various semi-conducting substrates which are commonly used for ion-implanted GaAs integrated circuits.

Another feature of the present invention is that it is suitable for monolithic radiation-hard focal planes which may be GaAs circuitry based on Schottky barrier technology. Such circuitry can withstand radiation including a total dosage of up to 100 MRad and a neutron fluence over $10^{15}$ per square centimeter. Dose rate sensitivity depends on associated circuitry of the detector and layout. Dose rate effects can be minimized by decreasing the thickness of the thin layer of the detector.

One embodiment of present invention is a moderately low-temperature IR detector having a bulk body of GaAs or other semiconductor material, that is sandwiched between ohmic metal and a thin layer of GaAs or other semiconductor material. The bulk body contains a low concentration of shallow donors. The thin layer contains a high concentration of shallow donors and deep donor-like traps. A Schottky metal layer is put on the side of the thin layer opposite of the side to the bulk body material. Another embodiment has a Schottky metal layer on a highly doped thin layer containing a high concentration of shallow donors and deep donor-like traps. The thin layer is set on a mesa structure which has a low concentration of shallow donors. The mesa structure in turn is set on a GaAs substrate which has a high concentration of shallow donors. Attached to the substrate is an ohmic contact. The substrate is set on semi-insulating GaAs.

The invention can be tuned broadly and narrowly. Deposition techniques, such as molecular beam epitaxy (MBE) and metalorganic chemical vapor deposition (MOCVD), may be used to fabricate the invention. Epitaxially-engineered Schottky diodes may be used to construct the IR detectors.

The present invention may be made from semiconductor materials selected from the group III-V of elements.

Brief Description of the Drawings

Figure 1 is a diagram of a monolithic IR detector having a Schottky barrier.

Figure 2 is a diagram of a monolithic IR detector having a mesa structure and graphs illustrating the detector's principle of operation in terms of the Schottky barrier.

Description of the Preferred Embodiments

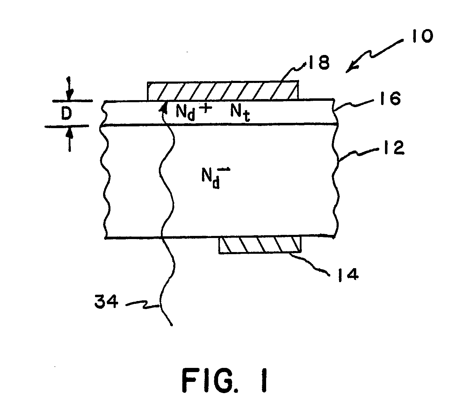

IR detector 10, as shown in figure 1, has bulk body 12 of gallium arsenide (GaAs) or other semiconductor material which contains a low concentration of shallow donors ($N_a^-$) at a concentration of approximately $10^{16}$ donors per cm$^3$. Ohmic metal 14 and active thin layer structure 16 sandwich bulk body 12. Schottky metal layer 18 is on layer 16. Thin layer 16 has a thickness D of about 100 angstroms or less. Layer 16 contains shallow donors ($N_a^+$) at a concentration of about $10^{17}$ to $10^{19}$ donors per cm$^3$. If tuneability is desired, deep donor-like traps ($N_t$) at a concentration of approximately $10^{17}$ to $10^{19}$ traps per cm$^3$ are also contained in layer 16.

Changing the concentration of $N_a^+$ changes the IR band of detection of device 10. For instance, for GaAs and WSi with the concentration of $N_a^+$ at $2.1 \times 10^{17}$, the wavelength of detection for device 10 is 11 microns at 77° Kelvin. The IR detector can be tuned.(i.e., broad tuneability), for example, from about 3 to 11 microns, by activation of $N_t$ traps with short wavelength radiation. The IR range can be decreased (i.e., narrow tuneability) up to 29 percent with a forward bias change.

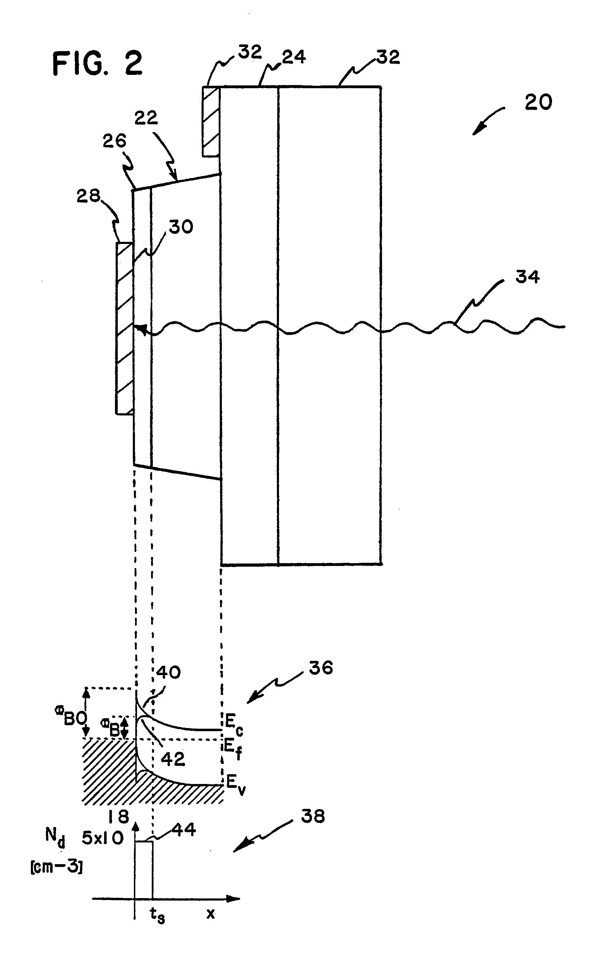

IR detector 20, as shown in figure 2, is an embodiment that overcomes a potential problem of IR detector 10 in figure 1 if substrate 12 is not sufficiently clean, thereby resulting in adverse effects on the operation of detector 10. Detector 20 isolates such effects with mesa structure 22. Layer 22 is about one micrometer thick and has shallow donors in a concentration of about or less than $10^{16}$ donors per cm$^3$. The fabrication of mesa structure 22 on substrate 24 is through epitaxial technology and subsequent etching. Active thin layer 26 is deposited on mesa structure 22. Layer 22 corresponds electrically to layer 12 of detector 10. Layer 26 corresponds to layer 16 of detector 10. Layer 26 may vary from under 100 angstroms to about 150 angstroms in thickness. Layer 26 is highly doped GaAs having shallow donors with as high as functionally possible concentration from about $10^{17}$ to $10^{19}$ donors per cm$^3$ and optional deep donor-like traps in a concentration from about $10^{17}$ to $10^{19}$ traps per cm$^3$. Upon layer 26 is Schottky metal layer 28 of which the contact between layers 26 and 28 form Schottky barrier 30. Metal layer 28 is used as a contact along with ohmic layer 24 for the electrical interface with device 20. Ohmic layer 24 is about 0.2 micrometer thick and contains shallow donors in a concentration from about $10^{17}$ to $10^{19}$ donors per cm$^3$. Layer 32 is a standard bulk semi-insulating GaAs.

The tuning properties of detector 20 are like those of detector 10. Detector 10 is a preferred embodiment but detector 20 is the more practicably realizable embodiment because of the clean substrate requirement for body 12 of detector 10, which is difficult to obtain with the yet present technologies.

Transmittance of layers 32, 24, 22 and 26 must be maximized and the absorption of layers 32, 24, 22 and 26 must be minimized, respectively, for IR radiation 34. The maximum substrate transmittance should be at least 55 percent for undoped GaAs considered from "bottom illumination," that is, for radiation 34 entering physically from the "bottom" through layers 32, 24, 22 and 26, respectively, through Schottky barrier 30 to Schottky metal layer 28. The need for transmittance is critical for high quantum efficiency of the device. High concentration doping of GaAs significantly attenuates IR radiation 34.

Graphs 36 and 38 illustrate the principle of operation in terms of the Schottky barrier. Curve 40 represents the potential barrier having a maximum height $\Phi_{BO}$ of an ordinary Schottky diode junction without a modifying effect upon it. Potential barrier height $\Phi_{BO}$ is not utilized in detectors 10 and 20. Curve 42 represents modified barrier height $\Phi_B$ which is implemented in detectors 10 and 20. The physical location of the barriers as represented by graphs 36 and 38 is shown with a layout correlation with detector 20. The correlation is similar for detector 10.

Potential barrier height $\Phi_{BO}$ is lowered to modified barrier height $\Phi_B$ as a result of the thin, highly doped layer 26 or 16 under Schottky metal 28 or 18, which can be achieved with high uniformity through the epitaxial fabrication process, e.g., MBE or MOCVD. The structure of layers 26 and 28 should be optimized to reduce the barrier height $\Phi_B$ to an energy (i.e., less than 0.2 eV) corresponding to a long wavelength IR range.

Other factors that enhance the lowering of the barrier, besides highly doped layer 26 or 16, include a dipole charge at interface 30 (i.e., Heine tails), an image force due to electrical charge accumulated on

3

interface 30 of the Schottky barrier area and thin layers 26 and 16, and tunneling of the electrons that shoot through barrier 42.

The IR photon energy of radiation 34 will cause electrons to move typically over barrier 42 from interface 30 through the area of layer 26. These electrons form the detector current.

The relationship of modified barrier height $\Phi_B$ of detector 20 or 10 to an unmodified barrier height $\Phi_{BO}$ of an ordinary Schottky diode junction, is indicated by the following equation.

$$\Phi_B = \Phi_{BO} - \frac{q\, E_m}{4\,\pi\, \epsilon_s} - \propto E_m$$

$E_m$ represents the value of the electric field at interface 30, q represents the electron charge, $\epsilon_\sigma$ represents the dielectric constant and $\alpha$ is the Andrews-Lepselter coefficient which was empirically determined by the authors Andrews and Lepselter. This equation approximates the value of the state-of-the-art lowering of the barrier.

Curves $E_c$, $E_f$ and $E_v$ of figure 2 represent energy levels and the energy band structure from interface 30 through layer 26 and structure 22. $E_c$ represents the bottom of conduction band energy, $E_f$ represents the Fermi energy level, and $E_v$ represents the top of valence band energy.

Curve 44 of graph 38 reveals the doping level of positive shallow donors with respect to the x dimension which corresponds to the thickness of detector 20 and the modified barrier height $\Phi_B$ as indicated by curve 42. A typical doping level is at a concentration of $5 \times 10^{18}$ donors per $cm^3$ from interface 30 through layer 26 to the border of contact between layer 26 and structure 22. The point $t_s$ represents both the doping drop-off level and the thickness of layer 26.

## Claims

1. A detector (10) having an infrared frequency band of detection, **characterized by:**
a low concentration doped base layer (12) of semiconductor material having a first surface and a second surface;
a high concentration doped thin layer (16) having a first surface in contact with the first surface of said doped base layer (12), and having a second surface;
a Schottky metal layer (18) having a first surface in contact with the second surface of said doped thin layer (16), and having a second surface; and
an ohmic layer (14) having a first surface in contact with the second surface of said doped base layer (16).

2. A detector (20) having an infrared frequency band of detection, **characterized by :**
a doped mesa structure layer (22) having a first surface and a second surface;
a doped thin layer (26) having a first surface in contact with the first surface of said doped mesa structure layer (22), and having a second surface;
a Schottky layer (28) having a first surface in contact with the second surface of said doped thin layer (26), and having a second surface;
a doped ohmic layer (24) having a first surface in contact with the second surface of said doped mesa structure layer (22), and having a second surface; and
a bulk semi-insulating layer (32) having a first surface in contact with the second surface of said ohmic layer.

3. Detector according to claim 1 or 2, **characterized in that** said high concentration doped thin layer (16, 26) has a thickness of about 100-200 Å between the first and second surfaces.

4. Detector according to claim 3, **characterized in that :**
said base or mesa layer (12, 22) semiconductor, respectively, contains a low concentration of shallow donors ($N_a^-$); and
said thin layer (16, 26) contains shallow donors ($N_a^+$) and donor-like traps ($N_t$).

5. Detector according to claim 4, **characterized in that** said detector (10, 20) is constructed with epitaxial engineering techniques.

6. Detector according to claim 5, **characterized in that** said doped base or mesa layer, respectively, is a semiconductor material from the group III-V; and
said doped thin layer (16, 26) is a semiconductor material from the group III-V.

7. Detector according to claim 6, **characterized in that:**

said Schottky layer (18, 28) has WSi material;

said doped base or mesa layer (12, 22), respectively, has GaAs material; and

said doped thin layer (16, 26) has GaAs material.

8. Detector according to claim 5, **characterized in that** said detector (10, 20) is constructed with molecular beam epitaxy.

9. Detector according to claim 5, **characterized in that** said detector (10, 20) is constructed with metalorganic chemical vapor deposition.

10. Detector according to claim 6, **characterized in that** changing the concentration of the shallow donors in said doped thin layer (16, 26) changes the infrared frequency tuneable range of detection.

11. Detector according to claim 10, **characterized in that** activating the deep donor-like traps with short wavelength radiation tunes the infrared frequency band detection.

12. Detector according to claim 11, further **characterized by** a forward bias voltage applied across said apparatus from said Schottky metal layer (18, 28) to said ohmic layer (14, 24), wherein changing the forward bias voltage changes the infrared frequency band of detection.

13. Detector according to claim 4, **character ized in that**:

the lightly doped shallow donors are contained in said base or mesa layer (12, 22) semiconductor, respectively, in a concentration of approximately $10^{16}$ donors per cubic centimeter:

the shallow donors are contained in said doped thin layer (16, 26) in a concentration range of about $10^{17}$ to $10^{19}$ donors per cubic centimeter; and

the deep donor-like traps are contained in said doped thin layer (16, 26) in a concentration range of about $10^{17}$ to $10^{19}$ donors per cubic centimeter.

FIG. I

# FIG. 2

32 24 32

22

26

28

30

20

34

36

40

$\Phi_{BO}$

$\Phi_B$

$E_c$

$E_f$

42

$E_v$

18

$N_d$  $5\times10$

[cm−3]

44

38

$t_s$

x